# FASCICULE DE BREVET EUROPEEN

(11) **EP 0 490 787 B1**
(45) Date de publication et mention de la délivrance du brevet: **04.09.1996**
(21) Numéro de dépôt: 91420430.0
(22) Date de dépôt: 03.12.1991
(51) Int. Cl.: H02H 9/04, H02H 3/04, H04M 3/18

(54) **Circuit de protection limitant les surtensions entre limites choisies et son intégration monolithique**
Überspannungen zwischen ausgewählten Grenzen begrenzende Schutzschaltung und deren monolitsche Integration
Protection circuit limiting overvoltages between selected limits and its monolithic integration

(30) Priorité: 07.12.1990 FR 9015640
(43) Date de publication de la demande: 17.06.1992
(73) Titulaire: SGS-THOMSON MICROELECTRONICS S.A., F-94250 Gentilly (FR)
(72) Inventeur: Bernier, Eric, F-37100 Tours (FR); Pezzani, Robert, F-37210 Vouvray (FR)
(74) Mandataire: de Beaumont, Michel

(56) Documents cités:
- FR-A- 2 433 845
- GB-A- 2 218 872
- US-A- 4 390 919

## Description

La présente invention concerne des circuits de protection contre les surtensions de lignes telles que des lignes téléphoniques, et vise plus particulièrement de tels circuits permettant d'établir des seuils différents de surtension positive et négative. En outre, la présente invention prévoit un tel circuit associable à un circuit de détection d'incident.

Pour atteindre ces objets, la présente invention prévoit un circuit de protection de lignes telles que des lignes téléphoniques contre des surtensions positive ou négative de valeurs minimales respectives données, comprenant entre un point commun, d'une part, et une première ligne, une deuxième ligne et la terre, d'autre part, des premier, deuxième et troisième eléments de protection, respectivement constitués d'une diode en anti-parallèle avec un thyristor dont l'anode est reliée au point commun et dont la gâchette reçoit un signal de polarisation, les premier et deuxième thyristors étant à gâchette de cathode et le troisième thyristor à gâchette d'anode. Dans ce circuit, chacun des premier et deuxième thyristors est associé à un transistor d'amplification de courant de gâchette, l'émetteur de chaque transistor étant relié à la gâchette du thyristor correspondant et le collecteur de chaque transistor étant relié à un deuxième point comnun connecté à la gâchette du troisième thyristor, la base commune des transistors étant reliée à une valeur de référence correspondant à l'une desdites valeurs minimales, d'où il résulte que, en cas de surtension, il circule un courant de terre.

En outre, la présente invention prévoit un mode d'intégration monolithique du circuit selon l'invention réalisé à partir d'un substrat de silicium de type N dont la face arrière correspond au point commun et dont la face avant comprend les diverses métallisations de liaison aux lignes, à la masse, et aux tensions de polarisation. Le thyristor à gâchette d'anode comprend, à partir de la face arrière, une couche surdopée de type P, le substrat correspondant à la gâchette d'anode, un caisson, de type P et, du côté de la face avant, une région de type N percée de courts-circuits d'émetteur, reliée à une métallisation de cathode. Chaque thyristor à gâchette de cathode comprend, à partir de la face arrière, une région de type P, le substrat, un caisson de type P correspondant à la gâchette de cathode et une région de type N munie de courts-circuits d'émetteur recouverte d'une métallisation de cathode. Chaque transistor d'amplification de gâchette est formé au voisinage du thyristor à gâchette d'anode et comprend, à partir de la face avant, un caisson de type P correspondant sa base dans lequel est formée une région de type N⁺ correspondant à son émetteur et reliée par une métallisation au caisson de gâchette du thyristor à gâchette de cathode correspondant, le collecteur de ce transistor correspondant au substrat et donc à la région de gâchette d'anode du thyristor à gâchette d'anode, la face arrière du substrat, en regard du caisson de base du transistor considéré, comprenant essentiellement une région de type P.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 représente un schéma de circuit de protection de ligne ;
la figure 2 représente un mode de réalisation d'un circuit de protection de ligne selon la présente invention ;
la figure 3 représente un exemple de structure monolithique mettant en oeuvre le circuit de la figure 3 ; et
la figure 4 représente à échelle agrandie une partie de la structure de la figure 3.

On notera que dans les diverses figures relatives à des représentations de structure intégrée, aucune échelle n'est respectée, les dimensions et épaisseurs des diverses couches étant arbitrairement rétrécies ou dilatées pour simplifier le tracé et la lisibilité des figures.

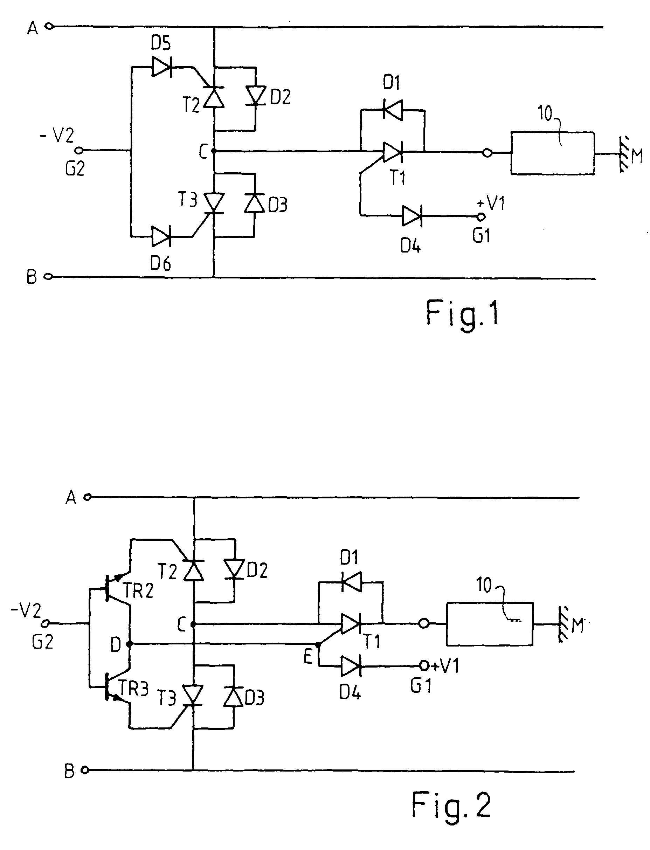

La figure 1 représente un circuit de protection adapté à deux lignes A et B et permettant d'écrêter des surtensions positives supérieures à une valeur V1 ou des surtensions négatives inférieures à une valeur -V2 par rapport à la terre. Ce circuit comprend trois thyristors T1, T2 et T3 dont les anodes sont reliées à un point commun C et dont les cathodes sont reliées respectivement à la masse M, à la première ligne A et à la deuxième ligne B. A chaque thyristor est associée une diode en anti-parallèle, respectivement D1, D2 et D3. Le thyristor T1 est un thyristor à gâchette d'anode et les thyristors T2 et T3 sont des thyristors à gâchette de cathode. La gâchette du thyristor T1 est reliée à une borne de commande G1 par l'intermédiaire d'une diode d'isolement D4. La borne G1 est reliée à une source de tension positive V1 légèrement inférieure à la tension positive que l'on veut écrêter. Les gâchettes des thyristors T2 et T3 sont reliées à une borne de commande G2 par l'intermédiaire de diodes d'isolement D5 et D6. La borne G2 est reliée à un potentiel -V2, la tension V2 étant légèrement inférieure à la tension négative que l'on veut écrêter.

Le fonctionnement de ce circuit est le suivant.

Une surtension positive sur la ligne A s'écoulera par la diode D2 et par le thyristor T1 rendu passant du fait que le potentiel sur le point C est supérieur au potentiel de commande V1 sur la grille G1.

De même une surtension positive sur la ligne B s'écoulera par la diode D3 et le thyristor T1.

Une surtension négative sur la ligne A rendra passant le thyristor T₂ et s'écoulera par ce thyristor et, ou bien vers la masse par la diode D1 ou bien vers l'autre ligne par la diode D3.

De même une surtension négative sur la ligne B s'écoulera par le thyristor T3 et vers la ligne A par la diode D2 ou vers la masse par la diode D1.

Ainsi, dans le cas d'une surtension négative, avec le montage de la figure 1, une surtension pourra s'écouler ou bien vers la masse ou bien vers l'autre ligne. Elle s'écoulera préférentiellement vers l'autre ligne si celle-ci est à un potentiel plus élevé que celui de la masse. Ceci présente un inconvénient pratique car, généralement, on souhaite dans les montages d'élimination de surtensions déterminer qu'un incident (une surtension) s'est produit. Pour cela, on utilise un détecteur 10 indiquant si du courant a circulé vers ou à partir de la masse. Dans le cas d'une surtension transmise d'une ligne sur l'autre, ce détecteur ne verra pas de passage de courant de masse et aucun incident ne sera signalé.

Pour résoudre ce problème, la présente invention prévoit un schéma du type de celui de la figure 2. Dans ce schéma, chacun des thyristors T2 et T3 est associé à un transistor, respectivement TR2 et TR3, d'amplification de courant de gâchette. Chacun des transistors est relié par son émetteur à la gâchette de cathode du thyristor correspondant et par sa base à la borne de commande G2. Les collecteurs des transistors TR2 et TR3 sont connectés à un point commun D relié à la gâchette E du thyristor à gâchette d'anode T1. Ainsi, quand une surtension négative se produit sur la ligne A, le thyristor T2 et le transistor TR2 deviennent passants. La mise en conduction du transistor TR2 entraîne, en raison de la connexion entre les points D et E le passage d'un courant de gâchette dans le thyristor T1 et le rend conducteur. Ainsi, un certain courant passera par la diode D3 et le thyristor T1 vers la masse en plus du courant passant par la diode D3 et le thyristor T2 pour résorber la surtension. Ainsi, le détecteur 10 fournira une détection d'incident.

Dans ce qui précède, on a supposé que les trois thyristors T1, T2, T3 étaient reliés par leurs anodes, que le thyristor T1 était un thyristor à gâchette d'anode et que les thyristors T2 et T3 étaient à gâchette de cathode. On pourrait symétriquement envisager que les thyristors T2, T3 et T1 soient reliés par leur cathode. En ce cas, le thyristor T1 serait remplacé par un thyristor à gâchette de cathode et les thyristors T2 et T3 par des thyristors à gâchette d'anode.

Un avantage du circuit de la figure 2, selon l'invention, est que, outre qu'il résout le problème de la détection d'incident sur une ligne, il peut être intégré de façon monolithique.

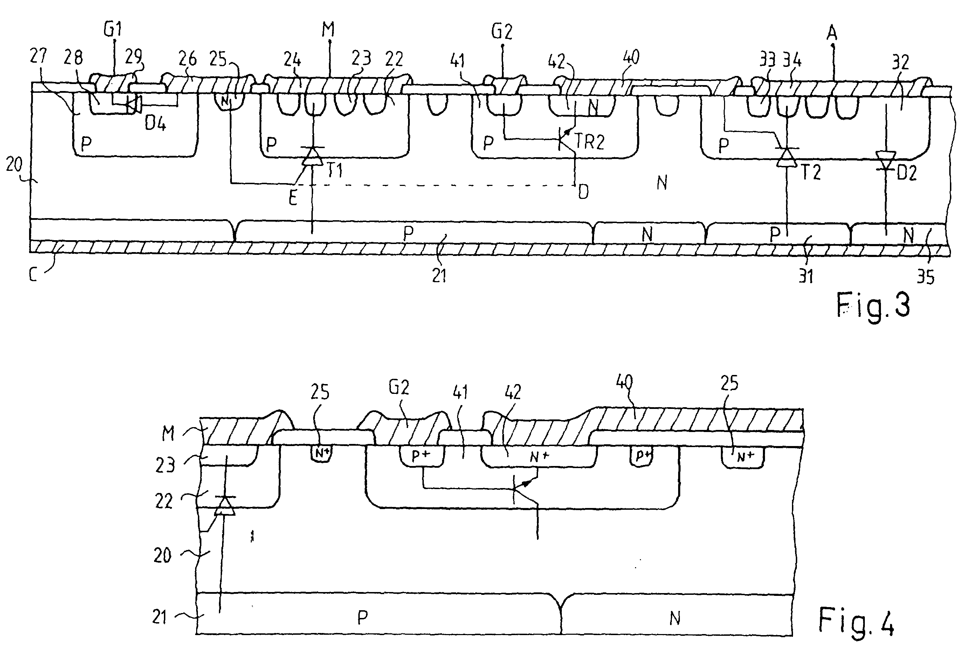

Une représentation simplifiée d'une telle intégration monolithique est illustrée partiellement en figure 3 où l'on a représenté la diode D4, le thyristor T1, le transistor TR2, le thyristor T2 et la diode D2. On n'a pas représenté la diode D1 associée au thyristor T1 comme la diode D2 au thyristor T2, ni l'ensemble T3, D3, TR3 semblable à l'ensemble T2, D2, TR2.

Le composant monolithique de la figure 3 est formé à partir d'une plaquette de silicium de type N 20 revêtue sur sa face arrière d'une métallisation C.

Le thyristor à gâchette d'anode T1 comprend, à partir de la face inférieure, une région P surdopée 21, le substrat 20, un caisson P 22 et une couche N munie de courts-circuits d'émetteur 23 et revêtue d'une métallisation 24 connectée à la masse, par l'intermédiaire du détecteur 10 (non représenté). La métallisation 24 recouvre aussi une partie non représentée du caisson 22, non recouverte de la couche 23, constituant l'anode de la diode D1. La région de gâchette d'anode du thyristor T1 est reprise, par l'intermédiaire d'une région surdopée de type N 25 par une métallisation 26 qui la relie à un caisson P 27 dans lequel est diffusé une région N 28, les régions 27 et 28 formant la diode D4. Une métallisation 29 recouvrant la région N 28 est reliée à la borne G1 destinée à être connectée à une source de polarisation positive +V1.

Le thyristor à gâchette de cathode T2 comprend, en partant de la face inférieure, une région P 31, le substrat N 20, un caisson P 32 et une région N 33 percée de courts-circuits d'émetteur et revêtue d'une métallisation d'anode 34 reliée à la ligne A.

La diode D2 est formée entre la métallisation 34 et la métallisation de face arrière C par le caisson P 32, le substrat N 20 et une couche surdopée N 35 du côté de la face inférieure.

Une métallisation 40 est en contact avec le caisson P 32 et correspond à la gâchette de cathode du thyristor T2.

Le transistor TR2 est représenté dans la partie centrale de la figure. Sa base correspond à un caisson de type P 41, son émetteur à une couche 42 formée dans ce caisson 41 et reliée par la métallisation 40 à la région de gâchette du thyristor T2. Le collecteur du transistor TR2 correspond au substrat N 20. Comme le montre mieux la figure 4 la diffusion P 21 d'anode du thyristor T1 se prolonge au moins partiellement sous la région N⁺ d'émetteur 42 de ce transistor TR2 de sorte qu'on peut considérer que le collecteur D du transistor TR2 est relié à la gâchette d'anode E du thyristor T1. Il faut bien entendu que le transistor TR2 soit disposé au voisinage immédiat du thyristor T1. Il en sera de même pour le transistor TR3 (non représenté).

L'homme de l'art notera que diverses variantes et modifications peuvent être apportées à la réalisation du circuit selon la présente invention. Par exemple, on a représenté sur la figure des régions surdopées N⁺ situées entre les caissons et servant d'arrêt de canal. Par ailleurs on n'a pas toujours représenté de région surdopée à l'emplacement de contact entre une métallisation et une couche sous-jacente. Une telle région sera nécessaire si la région avec laquelle la métallisation est en contact n'est pas suffisamment dopée.

L'homme de l'art notera également qu'un avantage de la réalisation selon la présente invention est qu'il n'est pas prévu de régions à diffusion profonde servant d'isolation électrique entre les composants élémentaires du circuit.

## Revendications

1. Circuit de protection de lignes, telles que des lignes téléphoniques, contre des surtensions positive ou négative de valeurs minimales respectives (+V₁ et -V₂) données, comprenant entre un point commun (C), d'une part, et une première ligne (A), une deuxième ligne (B) et la terre (M), d'autre part, des premier, deuxième et troisième éléments de protection, respectivement constitués d'une diode (D1, D2, D3) en anti-parallèle avec un thyristor (T1, T2, T3) dont l'anode est reliée au point commun et dont la gâchette reçoit un signal de polarisation, les premier et deuxième thyristors étant à gâchette de cathode et le troisième (T1) à gâchette d'anode, caractérisé en ce que chacun des premier et deuxième thyristors est associé à un transistor (TR2, TR3) d'amplification de courant de gâchette, l'émetteur de chaque transistor étant relié à la gâchette du thyristor correspondant et le collecteur de chaque transistor étant relié à un deuxième point commun (D) connecté à la gâchette du troisième thyristor, la base commune des transistors (TR2, TR3) étant reliée à une valeur de référence correspondant à l'une desdites valeurs minimales (+V₁ et -V₂), d'où il résulte que, en cas de surtension, il circule un courant de terre.

2. Circuit de protection de lignes, telles que des lignes téléphoniques, contre des surtensions positive ou négative de valeurs minimales respectives (+V₁ et -V₂) données, comprenant entre un point commun (C), d'une part, et une première ligne (A), une deuxième ligne (B) et la terre (M), d'autre part, des premier, deuxième et troisième éléments de protection, respectivement constitués d'une diode (D1, D2, D3) en anti-parallèle avec un thyristor (T1, T2, T3) dont la cathode est reliée au point commun et dont la gâchette reçoit un signal de polarisation; les premier et deuxième thyristors étant à gâchette d'anode et le troisième (T1) à gâchette de cathode, caractérisé en ce que chacun des premier et deuxième thyristors est associé à un transistor (TR2, TR3) d'amplification de courant de gâchette, l'émetteur de chaque transistor étant relié à la gâchette du thyristor correspondant et le collecteur de chaque transistor étant relié à un deuxième point commun (D) connecté à la gâchette du troisième thyristor, la base commune des transistors (TR2, TR3) étant reliée à une valeur de référence correspondant à l'une desdites valeurs minimales (+V₁ et -V₂), d'où il résulte que, en cas de surtension, il circule un courant de terre.

3. Circuit de protection selon l'une des revendications 1 ou 2, caractérisé en ce que la base de chaque transistor et la gâchette du troisième thyristor sont reliées à des tensions de polarisation respectives.

4. Structure monolithique incorporant les éléments du circuit de protection selon la revendication 1, réalisée à partir d'un substrat de silicium (20) de type N dont la face arrière correspond au point commun et dont la face avant comprend les diverses métallisations de liaison aux lignes, à la masse, et aux tensions de polarisation,
le thyristor à gâchette d'anode (T1) comprenant, à partir de la face arrière : une couche surdopée de type P (21), le substrat (20) correspondant à la gâchette d'anode, un caisson (22) de type P et, du côté de la face avant, une région (23) de type N percée de courts-circuits d'émetteur, reliée à une métallisation de cathode (24), et
chaque thyristor à gâchette de cathode (T2, T3) comprenant, à partir de la face arrière, une région (31) de type P, le substrat (20), un caisson (32) de type P correspondant à la gâchette de cathode et une région (33) de type N munie de courts-circuits d'émetteur recouverte d'une métallisation de cathode (34),
caractérisée en ce que chaque transistor d'amplification de gâchette (TR1, TR2) est formé au voisinage du thyristor à gâchette d'anode et comprend, à partir de la face avant, un caisson (41) de type P correspondant à sa base dans lequel est formée une région (42) de type N⁺ correspondant à son émetteur et reliée par une métallisation (40) au caisson de gâchette du thyristor à gâchette de cathode correspondant, le collecteur de ce transistor correspondant au substrat et donc à la région de gâchette d'anode du thyristor à gâchette d'anode, la face arrière du substrat, en regard du caisson de base du transistor considéré, comprenant essentiellement une région de type P (21).

## Patentansprüche

1. Schaltung zum Schützen von Leitungen, wie beispielsweise Telephonleitungen, vor positiven oder negativen Überspannungen mit jeweiligen bestimmten Minimalwerten (+V1 und -V2), wobei die Schaltung zwischen einem gemeinsamen Punkt (C) einerseits und einem ersten Leiter (A), einem zweiten Leiter (B) und Masse (M) andererseits erste, zweite bzw. dritte Schutzbauteile bzw. -komponenten aufweist, die jeweils durch eine Diode (D1, D2, D3) gebildet werden, die anti-parallel bzw. umgekehrt parallel mit einem Thyristor (T1, T2, T3) verbunden ist, dessen Anode mit dem gemeinsamen Punkt verbunden ist und dessen Gatter bzw. Gate ein Polarisations- bzw. Vorspannungssignal empfängt, wobei der erste und der zweite Thyristor vom Kathoden-Gate-Typ sind und wobei der dritte Thyristor (T1) vom Anoden-Gate-Typ ist, dadurch gekennzeichnet, daß der erste und der zweite Thyristor jeweils mit einem Transistor (TR2, TR3) zur Verstärkung des Gate-Stroms assoziiert ist, wobei der Emitter jedes Transistors mit dem Gate des entsprechenden Thyristors verbunden ist und wobei der Kollektor jedes Transistors mit einem zweiten gemeinsamen Punkt (D) verbunden ist, welcher mit dem Gate des dritten Thyristors verbunden ist, wobei die gemeinsame Basis der Transistoren (TR2, TR3) mit einem Bezugswert bzw. einer Bezugsspannung verbunden ist, der bzw. die einem der Minimalwerte (+V1 und -V2) entspricht, wodurch im Fall einer Überspannung ein Massestrom fließt.

2. Schaltung zum Schützen von Leitungen, wie beispielsweise Telephonleitungen, vor positiven oder negativen Überspannungen mit jeweiligen bestimmten Minimalwerten (+V1 und -V2), wobei die Schaltung zwischen einem gemeinsamen Punkt (C) einerseits und einem ersten Leiter (A), einem zweiten Leiter (B) und Masse (M) andererseits erste, zweite bzw. dritte Schutzbauteile bzw. -komponenten aufweist, die jeweils durch eine Diode (D1, D2, D3) gebildet werden, die anti-parallel bzw. umgekehrt parallel mit einem Thyristor (T1, T2, T3) verbunden ist, dessen Kathode mit dem gemeinsamen Punkt verbunden ist und dessen Gatter bzw. Gate ein Polarisations- bzw. Vorspannungssignal empfängt, wobei der erste und der zweite Thyristor vom Anoden-Gate-Typ sind und wobei der dritte Thyristor (T1) vom Kathoden-Gate-Typ ist, dadurch gekennzeichnet, daß der erste und der zweite Thyristor jeweils mit einem Transistor (TR2, TR3) zur Verstärkung des Gate-Stroms assoziiert ist, wobei der Emitter jedes Transistors mit dem Gate des entsprechenden Thyristors verbunden ist und wobei der Kollektor jedes Transistors mit einem zweiten gemeinsamen Punkt (D) verbunden ist, welcher mit dem Gate des dritten Thyristors verbunden ist, wobei die gemeinsame Basis der Transistoren (TR2, TR3) mit einem Bezugswert bzw. einer Bezugsspannung verbunden ist, der bzw. die einem der Minimalwerte (+V1 und -V2) entspricht, wodurch im Fall einer Überspannung ein Massestrom fließt.

3. Schutzschaltung gemäß Anspruch 1 oder 2, dadurch gekennzeichnet, daß die Basis jedes Transistors und das Gate des dritten Thyristors mit jeweiligen Polarisations- bzw. Vorspannungen verbunden sind.

4. Monolithische Struktur, welche die Elemente der Schutzschaltung gemäß Anspruch 1 umfaßt und die aus einem N-Typ-Silizium-Substrat (20) erhalten wurde, dessen Rückseite dem gemeinsamen Punkt entspricht und dessen Vorderseite verschiedene Metallisierungen zur Verbindung mit den Leitern, der Masse und mit Polarisations- bzw. Vorspannungen aufweist, wobei der Anoden-Gate-Thysistor (T1) von der Rückseite her folgendes aufweist: eine P-Typ-überdotierte Schicht (21), das Substrat (20), das dem Anoden-Gate entspricht, eine P-Typ-Senke (22) und auf der Vorderseite einen N-Typ-Bereich (23), der von Emitterkurzschlüssen durchdrungen ist und mit einer Kathoden-Metallisierung (24) verbunden ist,
wobei jeder Kathoden-Gate-Thyristor (T2, T3) von der Rückseite her folgendes aufweist: einen P-Typ-Bereich (31), das Substrat (20), eine P-Typ-Senke (32), die dem Kathoden-Gate entspricht, und einen N-Typ-Bereich (33), der mit Emitterkurzschlüssen versehen ist und mit einer Kathoden-Metallisierung (34) überzogen ist, dadurch gekennzeichnet, daß jeder Gate-Verstärkungs-Transistor (TR1, TR2) benachbart zu dem Anoden-Gate-Thyristor ausgebildet ist und von der Vorderseite her folgendes aufweist: eine P-Typ-Senke (41), die seiner Basis entspricht und in der ein N⁺-Typ-Bereich (42) ausgebildet ist, der seinem Emitter entspricht und durch eine Metallisierung (40) mit der Gate-Senke des entsprechenden Kathoden-Gate-Thyristors verbunden ist, wobei der Kollektor des entsprechenden Transistors dem Substrat und somit dem Anoden-Gate-Bereich des Anoden-Gate-Thyristors entspricht, wobei die Rückseite des Substrats gegenüber der Basis-Senke des betreffenden Transistors im wesentlichen einen P-Typ-Bereich (21) aufweist.

## Claims

1. A circuit for protecting lines, such as telephone lines, against positive or negative overvoltages having respective determined minimum values (+V1 and -V2), comprising between a common point (C), on the one hand, and a first conductor (A), a second conductor (B) and ground (M), on the other, first, second and third protection components, respectively constituted by a diode (D1, D2, D3) parallel, head-to-tail connected to a thyristor (T1, T2, T3), the anode of which is connected to said common point and the gate of which receives a polarization signal, the first and second thyristors being of the cathode-gate type and the third (T1) of the anode-gate type, characterized in that each of the first and second thyristors is associated with a transistor (TR2, TR3) for amplifying the gate current, the emitter of each transistor being connected to the gate of the corresponding thyristor and the collector of each transistor being connected to a second common point (D) connected to the gate of the third thyristor, the common base of the transistors (TR2, TR3) being connected to a reference value corresponding to one of said minimum values (+V1 and -V2), whereby a ground current flows further to an overvoltage.

2. A circuit for protecting lines, such as telephone lines, against positive or negative overvoltages having respective determined minimum values (+V1 and -V2), comprising between a common point (C), on the one hand, and a first conductor (A), a second conductor (B) and ground (M), on the other, first, second and third protection components, respectively constituted by a diode (D1, D2, D3) in anti-parallel with a thyristor (T1, T2, T3), the cathode of which is connected to said common point and the gate of which receives a polarization signal, the first and second thyristors being of the anode-gate type and the third (T1) of the cathode-gate type, characterized in that each of said first and second thyristors is associated with a transistor (TR2, TR3) for amplifying the gate current, the emitter of each transistor being connected to the gate of the corresponding thyristor and the collector of each transistor being connected to a second common point (D) connected to the gate of said third thyristor, the common base of the transistors (TR2, TR3) being connected to a reference value corresponding to one of said minimum values (+V1 and -V2), whereby a ground current flows further to an overvoltage.

3. A protection circuit according to claim 1 or 2, characterized in that the base of each transistor and the gate of said third thyristor are connected to respective polarization voltages.

4. A monolithic structure incorporating the elements of the protection circuit according to claim 1, achieved from an N-type silicon substrate (20), the rear surface of which corresponds to the common point and the front surface comprises various connection metallizations to said conductors, to ground and to biasing voltages,
said anode-gate thyristor (T1) comprising, from the rear surface: a P-type overdoped layer (21), the substrate (20) corresponding to the anode gate, a P-type well (22) and, on the front surface side, an N-type region (23) provided with emitter shorts, connected to a cathode metallization (24),
each cathode-gate thyristor (T2, T3) comprising, from the rear surface, a P-type region (31), substrate (20), a P-type well (32) corresponding to the cathode gate and an N-type region (33) provided with emitter shorts and coated with a cathode metallization (34),
characterized in that each gate amplification transistor (TR1, TR2) being formed close to the anode-gate thyristor and comprising, from the front surface, a P-type well (41) corresponding to its base wherein is formed an N⁺-type region (42) corresponding to its emitter and connected by a metallization (40) to the gate well of said corresponding cathode-gate thyristor, the collector of said transistor corresponding to the substrate and therefore to the anode-gate region of said anode-gate thyristor, the rear surface of the substrate, facing the base well of the considered transistor, mainly comprising a P-type region (21).
